# EUROPEAN PATENT SPECIFICATION

(11) **EP 4 650 912 B1**
(45) Date of publication and mention of the grant of the patent: **07.10.2026**
(21) Application number: 25175604.5
(22) Date of filing: 12.05.2025
(51) Int. Cl.: G06F 1/20

(54) **HEAT DISSIPATION DEVICE**
WÄRMEABLEITUNGSVORRICHTUNG
DISPOSITIF DE DISSIPATION DE CHALEUR

(30) Priority: 17.05.2024 TW 113205140 U
(43) Date of publication of application: 19.11.2025
(73) Proprietor: Cooler Master Co., Ltd., Taipei City 114065 (TW)
(72) Inventor: LIN, CHIEN-LIANG, 114065 Taipei City (TW); LIN, TSUNG-WEI, 114065 Taipei City (TW); LIAO, PEN-HUNG, 114065 Taipei City (TW)
(74) Representative: Grünecker Patent- und Rechtsanwälte PartG mbB

(56) References cited:
- ANONYMOUS: "iCUE LINK H100i | H150i | H170i LCD AIO ALL-IN-ONE LIQUID CPU COOLER WITH LCD SCREEN BEFORE YOU START", 31 December 2023 (2023-12-31), pages 1 - 31, XP093321421, Retrieved from the Internet <URL:https://www.corsair.com/us/en/explorer/diy-builder/cpu-coolers/icue-link-h100i-h150i-h170i-lcd-aio/> [retrieved on 20251002]

## Description

### TECHNICAL FIELD

The present disclosure is related to the field of liquid cooling radiators, in particular a liquid cooling radiator having a peripheral interface.

### BACKGROUND

Liquid cooling systems are commonly employed in high-performance computing environments to efficiently dissipate heat generated by processors, graphics cards, and other heat-intensive components. These systems typically include a pump, tubing, a water block, and a radiator that facilitates heat exchange between the coolant and the surrounding air.

While conventional liquid cooling radiators are effective at managing thermal performance, they typically serve only one function-heat dissipation-and do not provide any additional connectivity or interface options. As modern computing systems increasingly require more peripheral devices, there is an increasing demand for better system space utilization and component integration.

"iCUE LINK H100i | H150i | H170i LCD AIO ALL-IN-ONE LIQUID CPU COOLER WITH LCD SCREEN BEFORE YOU START", 31 December 2023, pages 1-31, URL: https://www.corsair.com/us/ en/explorer/diy-builder/cpu-coolers/icue-link-h100i-h150i-h170i-lcd-aio/, discloses a cooling radiator with an affixed hub by means of a magnet or adhesive tape. The magnet or adhesive tape solves the problem of mounting the hub to the cooling radiator.

### SUMMARY

The invention is as defined in the appended claims. Aspects of the disclosure provide a hub assembly for a liquid cooling radiator having two pipeline joints that each includes a ring groove on an outer surface. The hub assembly includes a hub base having a mounting portion that is disposed between two connecting portions, each connecting portion being configured to partially surround one of the pipeline joints at the respective ring groove, and two clamping structures that each connect to one of the connecting portions and are configured to partially surround one of the pipeline joints at the respective ring groove, wherein the hub base is secured to the liquid cooling radiator by clamping the pipeline joints between the respective clamping structures and the respective connection portions.

In an embodiment, each of the connecting portions includes a clamping channel for the clamping structure to be inserted, the clamping channel runs through the connecting portion in a direction from an end of the connecting portion away from the mounting portion to an end of the connecting portion adjacent to the mounting portion.

In an embodiment, the clamping channel is a U-shape and distance between two branches is smaller than a diameter of the ring groove, and the clamping channel is recessed inward at the end of the connecting portion away from the mounting portion.

In an embodiment, each of the clamping structures is a U-shape structure and inserted into the respective clamping channel for clamping the respective pipeline joint at the ring groove.

In an embodiment, each of the clamping structures includes a protruding structure on a surface facing the pipeline joint, the protruding structure is disposed in the ring groove of the respective pipeline joint.

In an embodiment, the clamping structures and the connecting portions includes corresponding screw holes, the clamping structures and the connecting portions are respectively connected by screws through the corresponding screw holes.

In an embodiment, the mounting portion includes a plurality of supporting columns and a plurality of locking structures, each locking structure includes a locking hole.

In an embodiment, the hub assembly further includes a hub box configured to be disposed on the mounting portion, the hub box includes a plurality of locking structures that lock on to the respective locking structures of the mounting portion via the locking holes. In some embodiments, the hub box includes at least one peripheral interface. For example, the peripheral interface is a USB port.

Aspects of the disclosure provide a hub assembly for a liquid cooling radiator having two pipeline joints that each includes a ring groove on an outer surface. The hub assembly includes a hub base having a mounting portion that is disposed between two connecting portions, each connecting portion being configured to include a through hole and each of the pipeline joints being configured to pass through the corresponding through hole, and two clamping structures that each connect to one of the connecting portions and are configured to partially surrounds one of the pipeline joints at the respective ring groove, wherein the hub base is secured on the liquid cooling radiator by clamping the pipeline joints with the respective clamping structures.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a perspective view of a liquid cooling radiator 30 according to aspects of the present disclosure.
Fig. 2 illustrates an partial exploded view of the liquid cooling radiator 30 as shown in Fig. 1.
Fig. 3 illustrates a perspective view of a hub base 10 of the liquid cooling radiator 30 as shown in Fig. 1.
Fig. 4 illustrates a perspective view of the hub base 10 in an alternative orientation as shown in Fig. 2.
Fig. 5 illustrates a top partially view of the hub base 10 as shown in Fig. 1.
Fig. 6 illustrates a cross-section view of the hub base 10 as shown in Fig. 1.
Fig. 7 illustrates the liquid cooling radiator 30 as shown in Fig. 1 assembled with a hub box 40.
Fig. 8 illustrates partial view of the liquid cooling radiator 30 as shown in Fig. 1 having a hub base 10A.
Fig. 9 illustrates partial exploded view of the liquid cooling radiator 30 as shown in Fig. 1 having the hub base 10A as shown in Fig. 8.
Fig. 10 illustrates a cross-section view of the hub base 10A as shown in Fig. 8.
Fig. 11 illustrates a liquid cooling radiator 90 according to aspects of conventional arts.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

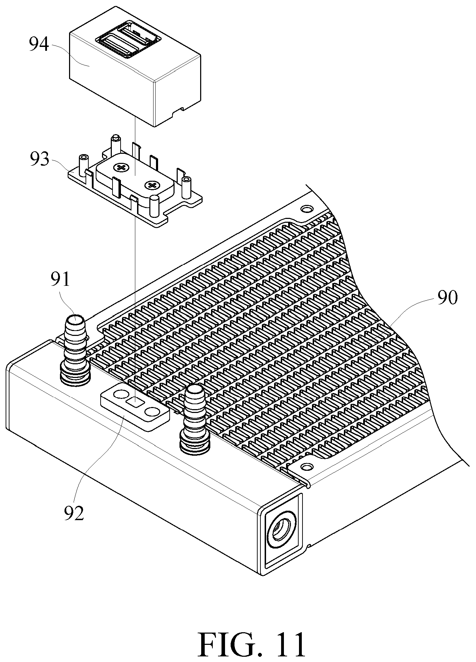

Fig. 11 illustrates a liquid cooling radiator 90 according to aspects of conventional arts. The liquid cooling radiator 90 includes two pipeline joints 91 disposed on a liquid chamber that is at one end of the liquid cooling radiator 90. A box structure 92 is disposed between the two pipeline joints 91. The box structure 92 includes a plurality of screw holes. The box structure 92 is used for mounting a base 93 which also includes a plurality of screw holes. The base 93 is mounted to the box structure 92 via screws through the respective screw holes on the box structure 92 and the base 93. The base 93 is used for setting up a hub assembly 94. The hub assembly 94 includes PCB board, USB connectors, *etc.,* for external connections. The assembled hub is used to provide additional USB connectors.

However, the box structure 92 is often welded onto the outer surface of the liquid cooling radiator first, and then it proceeds with assembly process of the hub assembly 94. This process is more time consuming and is risking the potential damage to the liquid cooling radiator during welding process. As a result of the above-mentioned flaws and weaknesses, there is an obvious demand for advancement.

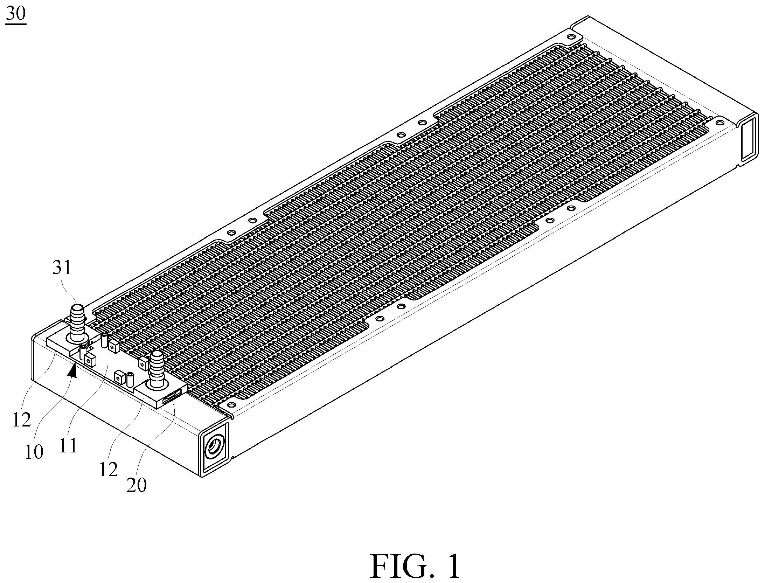

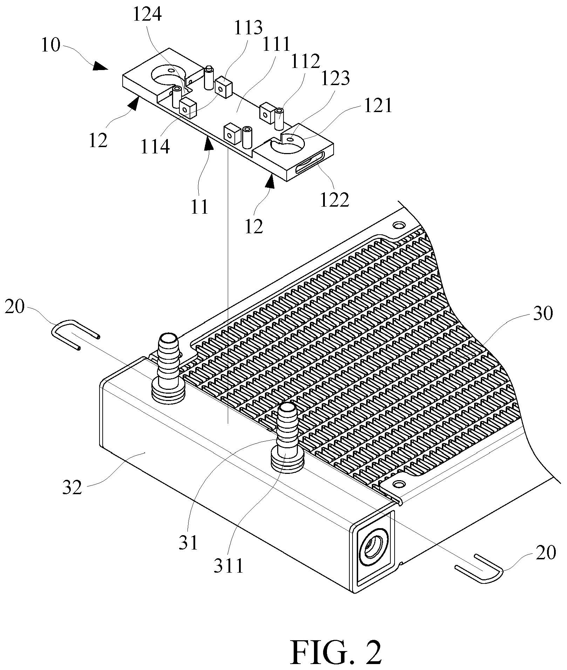

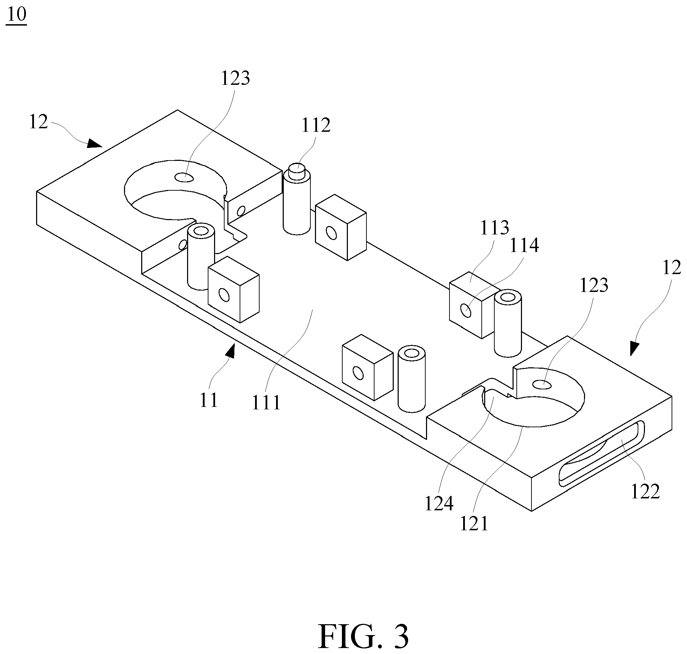

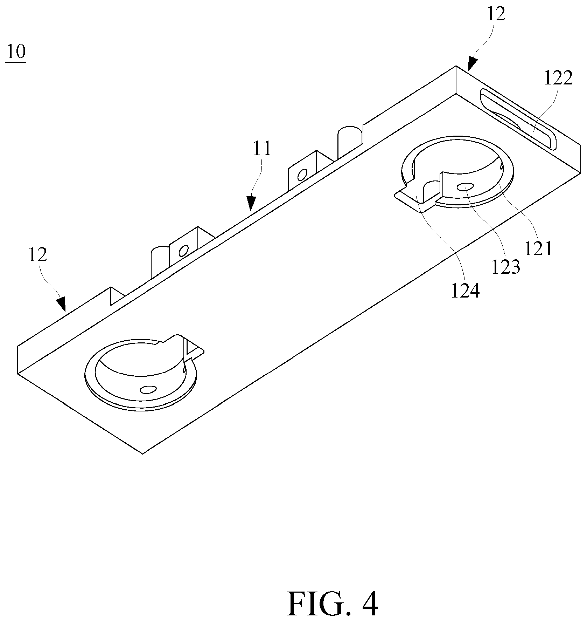

Please refer to Figs. 1-4. Fig. 1 illustrates a perspective view of a liquid cooling radiator 30 according to aspects of the present disclosure. Fig. 2 illustrates a partial exploded view of the liquid cooling radiator 30 as shown in Fig. 1. Fig. 3 illustrates a perspective view of a hub base 10 of the liquid cooling radiator 30 as shown in Fig. 1. Fig. 4 illustrates a perspective view of the hub base 10 in an alternative orientation as shown in Fig. 3.

The liquid cooling radiator 30 includes two pipeline joints 31 that can be used to connect inlet or outlet water lines. The two pipeline joints 31 are disposed on the liquid chamber 32. Each of the pipeline joint 31 includes a ring groove 311. The liquid cooling radiator 30 also includes a hub base 10 which further includes a mounting portion 11 and two connecting portions 12. The mounting portion 11 is disposed between the two connecting portions 12. The mounting portion 11 includes a bottom plate 111, a plurality of supporting columns 112 and a plurality of locking structures 113. The supporting columns 112 and locking structures 113 are disposed on the bottom plate 111. Each of the locking structures 113 includes a locking hole 114. The components disposed on the bottom plate can be modified according to the specific usage of the liquid cooling radiator 30.

The two connecting portions 12 are disposed symmetrically on the ends of the mounting portion 11. Each connecting portion 12 includes a connecting hole 121 and a clamping channel 122. The connecting hole 121 is used to allow the pipeline joint 31 to pass through. That is, the hub base 10 is disposed on the liquid cooling radiator 30 by having the two pipeline joints 31 pass through the respective connecting holes 121. The clamping channel 122 is disposed on the respective opposite ends of the hub base 10. The clamping channel 122 is recessed inward at the end surface. In one embodiment, the clamping channel 122 has a U-shape. In some embodiments, the clamping channel 122 can have other shape.

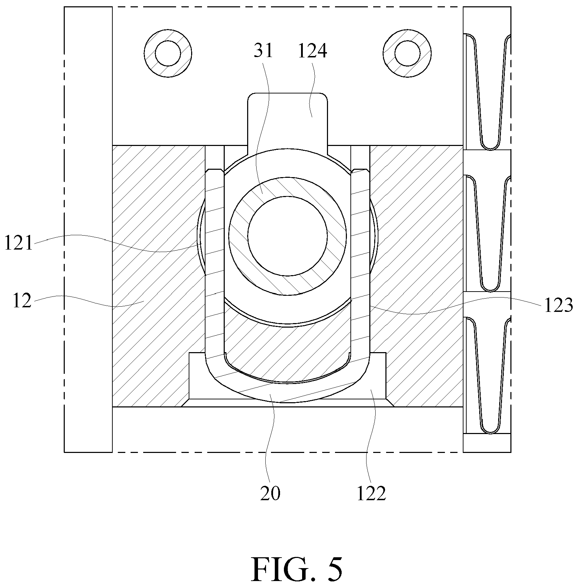

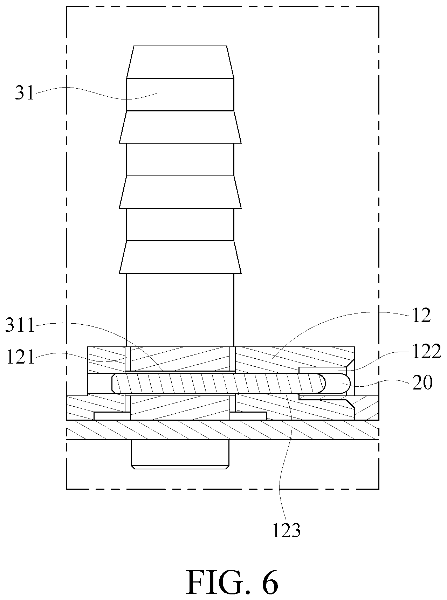

The clamping channel 122 allows a clamp 20 to be inserted to secure the hub base 10 on the pipeline joints 31. Refer to Figs. 5 and 6, where Fig. 5 illustrates a top partially view of the hub base 10 as shown in Fig. 1, and Fig. 6 illustrates a cross-section view of the hub base 10 as shown in Fig. 1. The clamp 20 can be a U-shaped elastic clamp that has the two ends slight bend towards each other. The shape of the clamp 20 can be modified according to the shape of the clamping channel 122. The width of the clamping channel 122 between the two branches is smaller than the diameter of the connecting hole 121, so that the clamp 20 can securely clamp the pipeline joint 31. Two clamping holes 123 is disposed on the inner surface of the connecting hole 121 and penetrates towards the mounting portion 11. The clamping holes 123 are configured for the respective ends of the clamp 20 to pass through to further secure the pipeline joints 31. An opening 124 is disposed at the position where the connecting portion 12 connects the mounting portion 11. The opening 124 connects with the connecting hole 121, and is configured to allow cable or wires to pass through. In some embodiments, the opening can be omitted or disposed at an alternative location on the mounting portion 11.

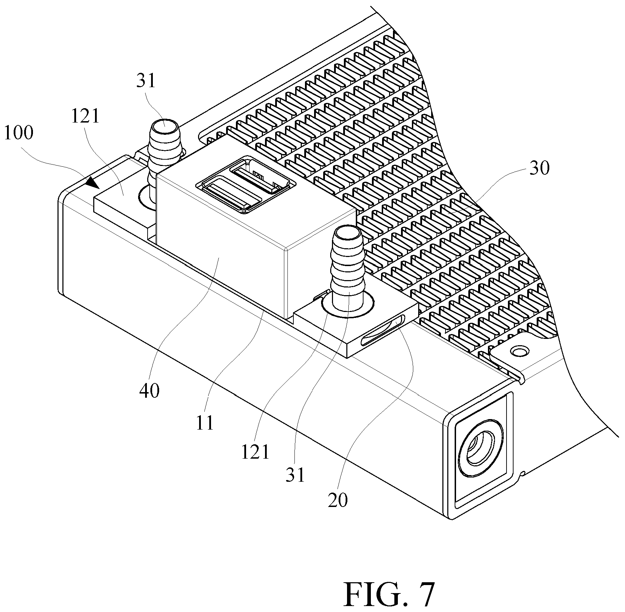

Also refer to Fig. 7, which illustrates the liquid cooling radiator 30 as shown in Fig. 1 assembled with a hub box 40. The hub box 40 can include PCB boards (not shown) having different types of USB ports or peripheral interfaces. The hub box 40 can be supported by the supporting columns 112. The hub box 40 can further include locking mechanisms or fastening mechanisms (not shown) to secure the hub box 40 to the hub base 10 via the locking structures 113 and the locking holes 114. This way, the hub box 40 and the hub case 10 are assembled into a hub assembly 100. Therefore, a liquid cooling radiator employing the abovementioned hub assembly can avoid additional welding process required for a peripheral interface hub. A hub assembly including the hub base and hub box, as described herein, facilitates a streamlined maintenance and repair process for the user while minimizing manufacturing costs and durations.

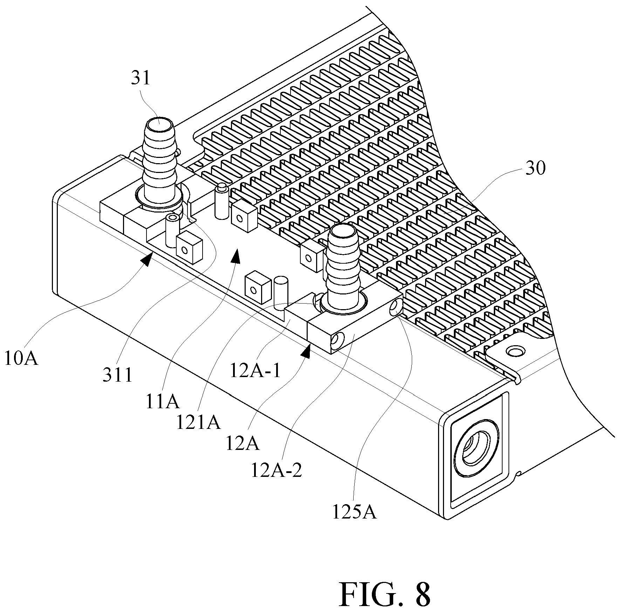

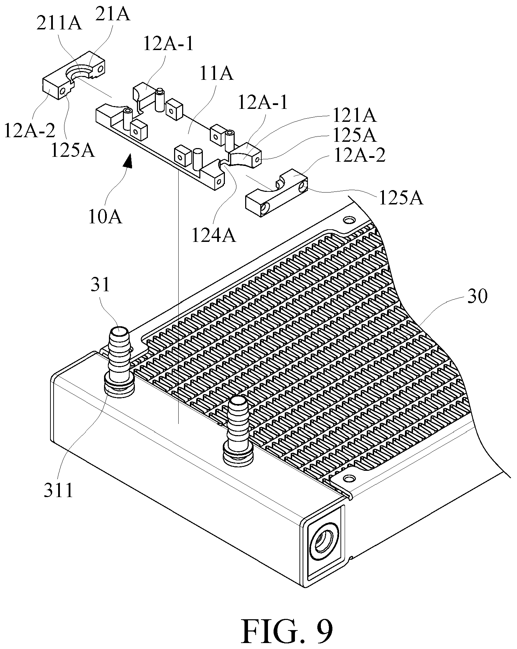

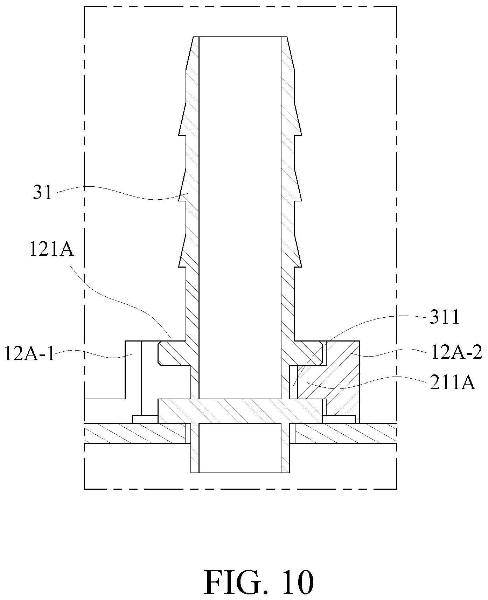

Refer to Figs. 8-10 for an embodiment of the hub base. Fig. 8 illustrates partial view of the liquid cooling radiator 30 as shown in Fig. 1 having a hub base 10A. Fig. 9 illustrates partial exploded view of the liquid cooling radiator 30 as shown in Fig. 1 having the hub base 10A. Fig. 10 illustrates a cross-section view of the hub base 10A as shown in Fig. 8.

The hub base 10A is similar to the hub base 10 as shown in Fig. 1. The mounting portion 11A of the hub base 10A is the same as the mounting portion 11 of the hub base 10. The differences are in the two connecting portions 12A. Each connecting portion 12A is divided into a first portion 12A-1 and a second portion 12A-2. The first portion 12A-1 is affixed to the mounting portion 11. The second portion 12A-2 is detachable relative to the first portion 12A-1. A connecting hole 121A is formed when the second portion 12A-2 is attached to the first portion 12A-1 similar to the connecting hole 121 of the hub base 10. A protruding structure 211A is disposed on an inner surface 21A of the second portion 12A-2. The protruding structure 211A, when the second portion 12A-2 is assembled with the first portion 12A-1, is configured to fit into the ring groove 311 of the pipeline joint 31. The first portion 12A-1 and the second portion 12A-2 have plurality of screw holes 125A that can be used to secure the second portion 12A-2 to the first portion 12A-1 via screws (not shown). In some embodiments, the second portion 12A-2 is fixed to the first portion 12A-1 by a fixing pin or any other suitable locking mechanisms. Similar to hub base 10 in Fig. 1, an opening 124A is disposed at the junction of the connecting portion 12A and the mounting portion 11A. The opening 124A and the connecting hole 121A are connected, which is configured to facilitate the passage of cables or wiring. In some embodiments, the opening can be omitted or disposed at an alternative location on the mounting portion 11A.

When assembling the hub base 10A onto the liquid cooling radiator 30, the mounting portion 11A along with the two first portions 12A-1 of the connecting portion 12A can be disposed between the two pipeline joints 31. The second portions 12A-2 of the connecting portion 12A can then be connected to the respective first portion 12A-1 by any suitable locking mechanism. In this way, the hub base 10A is securely fixed onto the liquid cooling radiator 30 by clamping both the pipeline joints 31. A hub box similar to the hub box 40 as shown in Fig. 7 can be attached to the hub base 10A to complete the hub assembly. The abovementioned hub assembly provides a secure solution to mount a peripheral interface hub while minimizing the manufacturing cost and durations.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope of the present disclosure

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A hub assembly (100) for a liquid cooling radiator (30) having two pipeline joints (31) that each includes a ring groove (311) on an outer surface, the hub assembly (100) comprising:
a hub base (10, 10A) having a mounting portion (11, 11A) that is disposed between two connecting portions (12, 12A), each connecting portion (12, 12A) being configured to partially surround one of the pipeline joints (31) at the respective ring groove (311); and
two clamping structures that each connect to one of the connecting portions (12, 12A) and are configured to partially surround one of the pipeline joints (31) at the respective ring groove (311),
wherein the hub base (10, 10A) is secured to the liquid cooling radiator (30) by clamping the pipeline joints (31) between the respective clamping structures and the respective connection portions (12).

2. The hub assembly (100) of claim 1, wherein each of the connecting portions (12) includes a clamping channel (122) for the clamping structure to be inserted, the clamping channel (122) runs through the connecting portion (12) in a direction from an end of the connecting portion (12) away from the mounting portion (11) to an end of the connecting portion (12) adjacent to the mounting portion (11).

3. The hub assembly (100) of claim 2, wherein the clamping channel (122) is a U-shape and distance between two branches is smaller than a diameter of the ring groove (311), and the clamping channel (122) is recessed inward at the end of the connecting portion (12) away from the mounting portion (11).

4. The hub assembly (100) of claim 2 or 3, wherein each of the clamping structures is a U-shape structure and inserted into the respective clamping channel (122) for clamping the respective pipeline joint (31) at the ring groove (311).

5. The hub assembly (100) of claim 1, wherein each of the clamping structures includes a protruding structure (211A) on a surface facing the pipeline joint (31), the protruding structure (211A) is disposed in the ring groove (311) of the respective pipeline joint (31).

6. The hub assembly (100) of claim 5, wherein the clamping structures and the connecting portions (12A) includes corresponding screw holes (125A), the clamping structures and the connecting portions (12A) are respectively connected by screws through the corresponding screw holes (125A).

7. The hub assembly (100) of claim 1, wherein the mounting portion (11) includes a plurality of supporting columns (112) and a plurality of locking structures (113), each locking structure (113) includes a locking hole (114).

8. The hub assembly (100) of claim 7, further comprises a hub box (40) configured to be disposed on the mounting portion (11), the hub box (40) includes a plurality of locking structures that lock on to the respective locking structures (113) of the mounting portion (11) via the locking holes (114).

9. The hub assembly (100) of claim 8, wherein the hub box (40) includes at least one peripheral interface.

10. The hub assembly (100) of claim 9, wherein the peripheral interface is a USB port.

11. A hub assembly (100) for a liquid cooling radiator (30) having two pipeline joints (31) that each includes a ring groove (311) on an outer surface, the hub assembly (100) comprising:
a hub base (10, 10A) having a mounting portion (11, 11A) that is disposed between two connecting portions (12, 12A), each connecting portion (12, 12A) being configured to include a through hole (121, 121A) and each of the pipeline joints (31) being configured to pass through the corresponding through hole (121, 121A); and
two clamping structures that each connect to one of the connecting portions (12, 12A) and are configured to partially surround one of the pipeline joints (31) at the respective ring groove (311),
wherein the hub base (10, 10A) is secured on the liquid cooling radiator (30) by clamping the pipeline joints (31) with the respective clamping structures.

12. The hub assembly (100) of claim 11, wherein each of the connecting portions (12) includes a clamping channel (122) for the clamping structure to be inserted, the clamping channel (122) runs through the connecting portion (12) in a direction from an end of the connecting portion (12) away from the mounting portion (11) to an end of the connecting portion (12) adjacent to the mounting portion (11).

13. The hub assembly (100) of claim 12, wherein the clamping channel (122) is a U-shape and a distance between two branches of the clamping channel (122) is smaller than a diameter of the ring groove (311), and the clamping channel (122) is recessed inward at the end of the connecting portion (12) away from the mounting portion (11).

14. The hub assembly (100) of claim 12 or 13, wherein each of the clamping structures is a U-shape structure and is inserted into the respective clamping channel (122) and clamps the respective pipeline joint (31) at the ring groove (311).

15. The hub assembly (100) of claim 11, wherein each of the through holes (121A) includes a protruding structure (211A) on an inner surface (21A), the protruding structure (211A) is disposed in the ring groove (311) of the respective pipeline joint (31).

16. The hub assembly (100) of claim 11, wherein the mounting portion (11) includes a plurality of supporting columns (112) and a plurality of locking structures (113), each locking structure includes a locking hole (114).

17. The hub assembly (100) of claim 16, further comprises a hub box (40) configured to be disposed on the mounting portion (11), the hub box (40) includes a plurality of locking structures that lock on to the respective locking structures (113) of the mounting portion (11) via the locking holes (114).

18. The hub assembly (100) of claim 17, wherein the hub box (40) includes at least one peripheral interface.

19. The hub assembly (100) of claim 18, wherein the peripheral interface is a USB port.

## Patentansprüche

1. Nabenbaugruppe (100) für einen flüssigkeitsgekühlten Radiator (30) mit zwei Rohrverbindungen (31), die jeweils eine Ringnut (311) an einer Außenfläche aufweisen, wobei die Nabenbaugruppe (100) umfasst:
eine Nabenbasis (10, 10A) mit einem Befestigungsabschnitt (11, 11A), der zwischen zwei Verbindungsabschnitten (12, 12A) angeordnet ist, wobei jeder Verbindungsabschnitt (12, 12A) so konfiguriert ist, dass er eine der Rohrverbindungen (31) an der jeweiligen Ringnut (311) teilweise umgibt; und zwei Klemmstrukturen, die jeweils mit einem der Verbindungsabschnitte (12, 12A) verbunden sind und so konfiguriert sind, dass sie eine der Rohrverbindungen (31) an der jeweiligen Ringnut (311) teilweise umgeben,
wobei die Nabenbasis (10, 10A) am flüssigkeitsgekühlten Radiator (30) befestigt ist, indem die Rohrverbindungen (31) zwischen den jeweiligen Klemmstrukturen und den jeweiligen Verbindungsabschnitten (12) eingeklemmt werden.

2. Nabenbaugruppe (100) nach Anspruch 1, wobei jeder der Verbindungsabschnitte (12) einen Klemmkanal (122) zum Einführen der Klemmstrukturen aufweist, wobei der Klemmkanal (122) durch den Verbindungsabschnitt (12) in einer Richtung von einem vom Befestigungsabschnitt (11) abgewandten Ende des Verbindungsabschnitts (12) zu einem zum Befestigungsabschnitt (11) benachbarten Ende des Verbindungsabschnitts (12) verläuft.

3. Nabenbaugruppe (100) nach Anspruch 2, wobei der Klemmkanal (122) U-förmig ist und ein Abstand zwischen zwei Schenkeln kleiner ist als ein Durchmesser der Ringnut (311), und wobei der Klemmkanal (122) am Ende des Verbindungsabschnitts (12), das vom Befestigungsabschnitt (11) entfernt ist, nach innen vertieft ist.

4. Nabenbaugruppe (100) nach Anspruch 2 oder 3, wobei jede der Klemmstrukturen eine U-förmige Struktur ist und in den jeweiligen Klemmkanal (122) eingesetzt ist, um die jeweilige Rohrverbindung (31) an der Ringnut (311) festzuklemmen.

5. Nabenbaugruppe (100) nach Anspruch 1, wobei jede der Klemmstrukturen eine vorstehende Struktur (211A) auf einer der Rohrverbindung (31) zugewandten Oberfläche aufweist, wobei die vorstehende Struktur (211A) in der Ringnut (311) der jeweiligen Rohrverbindung (31) angeordnet ist.

6. Nabenbaugruppe (100) nach Anspruch 5, wobei die Klemmstrukturen und die Verbindungsabschnitte (12A) übereinstimmende Schraubenlöcher (125A) aufweisen und die Klemmstrukturen und die Verbindungsabschnitte (12A) jeweils mittels Schrauben durch die übereinstimmenden Schraubenlöcher (125A) miteinander verbunden sind.

7. Nabenbaugruppe (100) nach Anspruch 1, wobei der Befestigungsabschnitt (11) mehrere Stützsäulen (112) und mehrere Verriegelungsvorrichtungen (113) umfasst, wobei jede Verriegelungsvorrichtung (113) ein Verriegelungsloch (114) aufweist.

8. Nabenbaugruppe (100) nach Anspruch 7, ferner umfassend ein Nabengehäuse (40), das so konfiguriert ist, dass es auf dem Befestigungsabschnitt (11) angeordnet werden kann, wobei das Nabengehäuse (40) eine Vielzahl von Verriegelungsstrukturen aufweist, die mittels der Verriegelungslöcher (114) an den jeweiligen Verriegelungsstrukturen (113) des Befestigungsabschnitts (11) verriegelt werden.

9. Nabenbaugruppe (100) nach Anspruch 8, wobei das Nabengehäuse (40) mindestens eine periphere Schnittstelle aufweist.

10. Nabenbaugruppe (100) nach Anspruch 9, wobei die periphere Schnittstelle ein USB-Anschluss ist.

11. Nabenbaugruppe (100) für einen flüssigkeitsgekühlten Radiator (30) mit zwei Rohrverbindungen (31), die jeweils eine Ringnut (311) an einer Außenfläche aufweisen, wobei die Nabenbaugruppe (100) umfasst:
eine Nabenbasis (10, 10A) mit einem Befestigungsabschnitt (11, 11A), der zwischen zwei Verbindungsabschnitten (12, 12A) angeordnet ist, wobei jeder Verbindungsabschnitt (12, 12A) so konfiguriert ist, dass er ein Durchgangsloch (121, 121A) aufweist, und wobei jede der Rohrverbindungen (31) so konfiguriert ist, dass sie durch das zugehörige Durchgangsloch (121, 121A) geführt wird; und
zwei Klemmstrukturen, die jeweils mit einem der Verbindungsabschnitte (12, 12A) verbunden sind und so konfiguriert sind, dass sie eine der Rohrverbindungen (31) an der jeweiligen Ringnut (311) teilweise umgeben,
wobei die Nabenbasis (10, 10A) am flüssigkeitsgekühlten Radiator (30) befestigt wird, indem die Rohrverbindungen (31) mit den jeweiligen Klemmstrukturen festgeklemmt werden.

12. Nabenbaugruppe (100) nach Anspruch 11, wobei jeder der Verbindungsabschnitte (12) einen Klemmkanal (122) zum Einführen der Klemmstrukturen aufweist, wobei der Klemmkanal (122) durch den Verbindungsabschnitt (12) in einer Richtung von einem vom Befestigungsabschnitt (11) abgewandten Ende des Verbindungsabschnitts (12) zu einem zum Befestigungsabschnitt (11) benachbarten Ende des Verbindungsabschnitts (12) verläuft.

13. Nabenbaugruppe (100) nach Anspruch 12, wobei der Klemmkanal (122) U-förmig ist und ein Abstand zwischen zwei Schenkeln des Klemmkanals (122) kleiner ist als ein Durchmesser der Ringnut (311), und wobei der Klemmkanal (122) am Ende des Verbindungsabschnitts (12), das vom Befestigungsabschnitt (11) entfernt ist, nach innen vertieft ist.

14. Nabenbaugruppe (100) nach Anspruch 12 oder 13, wobei jede der Klemmstrukturen eine U-förmige Struktur ist und in den jeweiligen Klemmkanal (122) eingesetzt ist und die jeweilige Rohrverbindung (31) an der Ringnut (311) festklemmt.

15. Nabenbaugruppe (100) nach Anspruch 11, wobei jedes der Durchgangslöcher (121A) eine vorstehende Struktur (211A) an einer Innenfläche (21A) aufweist, wobei die vorstehende Struktur (211A) in der Ringnut (311) der jeweiligen Rohrverbindung (31) angeordnet ist.

16. Nabenbaugruppe (100) nach Anspruch 11, wobei der Befestigungsabschnitt (11) mehrere Stützsäulen (112) und mehrere Verriegelungsvorrichtungen (113) umfasst, wobei jede Verriegelungsvorrichtung (113) ein Verriegelungsloch (114) aufweist.

17. Nabenbaugruppe (100) nach Anspruch 16, ferner umfassend ein Nabengehäuse (40), das so konfiguriert ist, dass es auf dem Befestigungsabschnitt (11) angeordnet werden kann, wobei das Nabengehäuse (40) eine Vielzahl von Verriegelungsstrukturen aufweist, die mittels der Verriegelungslöcher (114) an den jeweiligen Verriegelungsstrukturen (113) des Befestigungsabschnitts (11) verriegelt werden.

18. Nabenbaugruppe (100) nach Anspruch 17, wobei das Nabengehäuse (40) mindestens eine periphere Schnittstelle aufweist.

19. Nabenbaugruppe (100) nach Anspruch 18, wobei die periphere Schnittstelle ein USB-Anschluss ist.

## Revendications

1. Ensemble de concentrateur (100) pour un radiateur de refroidissement liquide (30) ayant deux raccords de tuyauterie (31) qui comprennent chacun une rainure annulaire (311) sur une surface extérieure, l'ensemble de concentrateur (100) comprenant :
une base de concentrateur (10, 10A) ayant une partie de montage (11, 11A) qui est disposée entre deux parties de liaison (12, 12A), chaque partie de liaison (12, 12A) étant configurée pour entourer partiellement l'un des raccords de tuyauterie (31) au niveau de la rainure annulaire respective (311) ; et
deux structures de serrage qui sont reliées chacune à l'une des parties de liaison (12, 12A) et sont configurées pour entourer partiellement l'un des raccords de tuyauterie (31) au niveau de la rainure annulaire respective (311),
dans lequel la base de concentrateur (10, 10A) est fixée au radiateur de refroidissement liquide (30) par serrage des raccords de tuyauterie (31) entre les structures de serrage respectives et les parties de liaison respectives (12).

2. Ensemble de concentrateur (100) selon la revendication 1, dans lequel chacune des parties de liaison (12) comprend un canal de serrage (122) destiné à l'insertion de la structure de serrage, le canal de serrage (122) s'étend à travers la partie de liaison (12) dans une direction allant d'une extrémité de la partie de liaison (12) éloignée de la partie de montage (11) vers une extrémité de la partie de liaison (12) adjacente à la partie de montage (11).

3. Ensemble de concentrateur (100) selon la revendication 2, dans lequel le canal de serrage (122) est en forme de U et la distance entre les deux branches est inférieure au diamètre de la rainure annulaire (311), et le canal de serrage (122) est en retrait vers l'intérieur au niveau de l'extrémité de la partie de liaison (12) éloignée de la partie de montage (11).

4. Ensemble de concentrateur (100) selon la revendication 2 ou 3, dans lequel chacune des structures de serrage présente une structure en forme en U et est insérée dans le canal de serrage respectif (122) pour serrer le raccord de tuyauterie respectif (31) au niveau de la rainure annulaire (311).

5. Ensemble de concentrateur (100) selon la revendication 1, dans lequel chacune des structures de serrage comprend une structure en saillie (211A) sur une surface tournée vers le raccord de tuyauterie (31), la structure en saillie (211A) est disposée dans la rainure annulaire (311) du raccord de tuyauterie respectif (31).

6. Ensemble de concentrateur (100) selon la revendication 5, dans lequel les structures de serrage et les parties de liaison (12A) comportent des trous de vis correspondants (125A), les structures de serrage et les parties de liaison (12A) sont respectivement reliées par des vis à travers les trous de vis correspondants (125A).

7. Ensemble de concentrateur (100) selon la revendication 1, dans lequel la partie de montage (11) comprend une pluralité de colonnes de support (112) et une pluralité de structures de verrouillage (113), chaque structure de verrouillage (113) comporte un trou de verrouillage (114).

8. Ensemble de concentrateur (100) selon la revendication 7, comprenant en outre un boîtier de concentrateur (40) configuré pour être disposé sur la partie de montage (11), le boîtier de concentrateur (40) comprend une pluralité de structures de verrouillage qui se verrouillent sur les structures de verrouillage respectives (113) de la partie de montage (11) via les trous de verrouillage (114).

9. Ensemble de concentrateur (100) selon la revendication 8, dans lequel le boîtier de concentrateur (40) comprend au moins une interface périphérique.

10. Ensemble de concentrateur (100) selon la revendication 9, dans lequel l'interface périphérique est un port USB.

11. Ensemble de concentrateur (100) pour un radiateur de refroidissement liquide (30) ayant deux raccords de tuyauterie (31) qui comprennent chacun une rainure annulaire (311) sur une surface extérieure, l'ensemble de concentrateur (100) comprenant :
une base de concentrateur (10, 10A) ayant une partie de montage (11, 11A) qui est disposée entre deux parties de liaison (12, 12A), chaque partie de liaison (12, 12A) étant configurée pour inclure un trou traversant (121, 121A) et chacun des raccords de tuyauterie (31) étant configuré pour passer à travers le trou traversant correspondant (121, 121A) ; et
deux structures de serrage qui sont reliées chacune à l'une des parties de liaison (12, 12A) et sont configurées pour entourer partiellement l'un des raccords de tuyauterie (31)au niveau de la rainure annulaire respective (311),
dans lequel la base de concentrateur (10, 10A) est fixée au radiateur de refroidissement liquide (30) par serrage des raccords de tuyauterie (31) avec les structures de serrage respectives.

12. Ensemble de concentrateur (100) selon la revendication 11, dans lequel chacune des parties de liaison (12) comprend un canal de serrage (122) destiné à l'insertion de la structure de serrage, le canal de serrage (122) s'étend à travers la partie de liaison (12) dans une direction allant d'une extrémité de la partie de liaison (12) éloignée de la partie de montage (11) vers une extrémité de la partie de liaison (12) adjacente à la partie de montage (11).

13. Ensemble de concentrateur (100) selon la revendication 12, dans lequel le canal de serrage (122) est en forme de U et la distance entre les deux branches du canal de serrage (122) est inférieure au diamètre de la rainure annulaire (311), et le canal de serrage (122) est en retrait vers l'intérieur au niveau de l'extrémité de la partie de liaison (12) éloignée de la partie de montage (11).

14. Ensemble de concentrateur (100) selon la revendication 12 ou 13, dans lequel chacune des structures de serrage présente une structure en forme de U et est insérée dans le canal de serrage respectif (122) et serre le raccord de tuyauterie respectif (31) au niveau de la rainure annulaire (311).

15. Ensemble de concentrateur (100) selon la revendication 11, dans lequel chacun des trous traversants (121A) comprend une structure en saillie (211A) sur une surface intérieure (21A), la structure en saillie (211A) est disposée dans la rainure annulaire (311) du raccord de tuyauterie respectif (31).

16. Ensemble de concentrateur (100) selon la revendication 11, dans lequel la partie de montage (11) comprend une pluralité de colonnes de support (112) et une pluralité de structures de verrouillage (113), chaque structure de verrouillage comprend un trou de verrouillage (114).

17. Ensemble de concentrateur (100) selon la revendication 16, comprenant en outre un boîtier de concentrateur (40) configuré pour être disposé sur la partie de montage (11), le boîtier de concentrateur (40) comprend une pluralité de structures de verrouillage qui se verrouillent sur les structures de verrouillage respectives (113) de la partie de montage (11) via les trous de verrouillage (114).

18. Ensemble de concentrateur (100) selon la revendication 17, dans lequel le boîtier de concentrateur (40) comprend au moins une interface périphérique.

19. Ensemble de concentrateur (100) selon la revendication 18, dans lequel l'interface périphérique est un port USB.
